# EUROPÄISCHE PATENTSCHRIFT

(11) **EP 1 653 651 B1**
(45) Veröffentlichungstag und Bekanntmachung des Hinweises auf die Patenterteilung: **07.09.2016**
(21) Anmeldenummer: 05015837.7
(22) Anmeldetag: 21.07.2005
(51) Int. Cl.: H04L 7/00, H04L 12/413, G05B 19/414, H04L 25/20, H04B 3/36

(54) **MODULARES NUMERISCHES STEUERGERÄT MIT LOW-JITTER SYNCHRONISATION**
MODULAR NUMERICAL CONTROLLER WITH LOW-JITTER SYNCHRONISATION
COMMANDE NUMÉRIQUE MODULAIRE AVEC SYNCHRONISATION LOW-JITTER

(30) Priorität: 27.10.2004 DE 102004052175
(43) Veröffentlichungstag der Anmeldung: 03.05.2006
(73) Patentinhaber: Dr. Johannes Heidenhain GmbH, 83292 Traunreut (DE)
(72) Erfinder: Zehentner, Georg, 83317 Teisendorf (DE)

(56) Entgegenhaltungen:
- EP-A- 1 408 386
- EP-A2- 0 504 907
- WO-A-03/028259
- DE-A1- 3 713 139
- US-A- 3 992 581
- SCHULTZE S: "Fault-tolerance in real-time communication" INDUSTRIAL ELECTRONICS, 1993. CONFERENCE PROCEEDINGS, ISIE'93 - BUDAPEST., IEEE INTERNATIONAL SYMPOSIUM ON BUDAPEST, HUNGARY 1-3 JUNE 1993, NEW YORK, NY, USA,IEEE, US, 1. Juni 1993 (1993-06-01), Seiten 583-587, XP010068588 ISBN: 0-7803-1227-9
- MINOBU HAYASHI ET AL: "MS SYNCHRONICATION NETWORKS USING DIGITAL SIGNAL PROCESSING PLL WITH DIFFERENT PHASE ERROR AVERAGING NUMBER IN EACH SLAVE LEVEL" ELECTRONICS & COMMUNICATIONS IN JAPAN, PART I - COMMUNICATIONS, WILEY, HOBOKEN, NJ, US, Bd. 75, Nr. 3, 1. März 1992 (1992-03-01), Seiten 12-19, XP000308012 ISSN: 8756-6621
- ANONYMOUS: 'SERCON816 SERCOS Interface Controller', [Online] 23 September 2002, STUTTGART, Seiten 1 - 30 Interests Group SERCOS interface Gefunden im Internet: <URL:http://www.sercos.com/literature/pdf/S ERCON816_Datasheet.pdf> [gefunden am 2010-01-13]

## Beschreibung

Die Erfindung betrifft ein modulares numerisches Steuergerät mit Low-Jitter Synchronisation nach Anspruch 1. Eine derartiges numerisches Steuergerät erlaubt eine Übermittlung von Daten von einem Hauptrechner zu den einzelnen Modulen mit konstanter Zeitverzögerung.

Numerische Steuergeräte (numerical control; NC) werden vorwiegend zur Steuerung von Werkzeugmaschinen eingesetzt und können im wesentlichen in zwei Funktionseinheiten unterteilt werden, einem Hauptrechner und wenigstens einer Reglereinheit.

Der Hauptrechner stellt die zur Bedienung der NC notwendigen Benutzerschnittstellen wie Tastatur und Monitor zur Verfügung und dient zur Erstellung, Speicherung und Abarbeitung von Programmen. In den Reglereinheiten befinden sich Regelkreise, die zur Ansteuerung von Umrichtermodulen dienen, die wiederum Motoren ansteuern. Außerdem umfassen die Reglereinheiten digitale und/oder analoge Schnittstellen zur Erfassung von Istwerten, die während eines Programmlaufs kontinuierlich zur Steuerung der Regelkreise benötigt werden. Bei den zu erfassenden Istwerten kann es sich beispielsweise um Positionswerte (Lagewerte), Geschwindigkeitswerte, Beschleunigungswerte oder auch Stromwerte handeln. Ebenso wie der Hauptrechner sind auch die Reglereinheiten mikroprozessorgesteuert.

Während der Abarbeitung eines Programms sendet der Hauptrechner den Reglereinheiten in regelmäßigen Zeitintervallen, deren Genauigkeit vom Verarbeitungstakt des Hauptrechners abhängt, Sollwerte als Vorgabe für die Regelkreise. Diese Sollwerte werden in einem Sollwert-Generator durch Unterteilung der Bahn zwischen einem Anfangspunkt und dem Endpunkt einer Verfahrbewegung erzeugt. Man spricht in diesem Zusammenhang auch von einer Satzverarbeitung. Parallel zum Eintreffen von Sollwerten erfassen die Reglereinheiten, ebenfalls in regelmäßigen Zeitintervallen, deren Genauigkeit jedoch vom Verarbeitungstakt der Reglereinheiten abhängt, Istwerte für die Regelkreise. In der Regel werden zwischen dem Eintreffen von zwei Sollwerten eine Vielzahl von Istwerten erfasst.

Häufig besteht der Wunsch, Hauptrechner und Reglereinheiten räumlich getrennt anzuordnen. So ist es sinnvoll, den Hauptrechner zusammen mit der Tastatur und dem Monitor in einem Gehäuse zusammenzufassen, um eine Benutzerschnittstelle zu schaffen, die nach ergonomischen Gesichtspunkten für den Anwender optimal platzierbar ist. Ebenso ist es wünschenswert, die Reglereinheiten nahe an den Umrichtern anzuordnen, um eine optimale Signalqualität der pulsbreitenmodulierten Steuersignale zu gewährleisten.

Für die Datenübertragung zwischen räumlich getrennten Einheiten bieten sich serielle Schnittstellen an, da hier Kabel mit nur wenigen Adern eingensetzt werden können, die im Vergleich zu Kabeln für die Datenübertragung über parallele Schnittstellen sehr preisgünstig und einfach handhabbar sind. Für den Fall, dass mehrere Reglereinheiten an einem Hauptrechner betrieben werden sollen, hat es sich als besonders vorteilhaft erwiesen, die Reglereinheiten mit dem Hauptrechner in Form einer Reihenschaltung zu verbinden, bei der die Datenübertragung mittels serieller Punkt zu Punkt Verbindungen realisiert wird. In einer solchen Architektur sendet der Hauptrechner Informationen in Form eines seriellen Datenstromes zur ersten Reglereinheit der Reihenschaltung, diese sendet die Informationen weiter zur nächsten Reglereinheit der Reihenschaltung usw. bis die Informationen bei der abschließenden Reglereinheit der Reihenschaltung eintreffen.

So beschreibt die EP 1 394 644 A1 ein numerisches Steuergerät, bestehend aus einer numerischen Steuereinheit und mehreren Motorsteuereinheiten, die über serielle Kommunikationsleitungen in Form einer Reihenschaltung miteinander verbunden sind. Zur Steuerung der Motorsteuereinheiten sendet die numerische Steuereinheit Daten, insbesondere Sollwerte, zur ersten Motorsteuerung der Reihenschaltung. Diese sendet die Daten weiter zur nächsten Motorsteuerung usw., bis die Daten schließlich die letzte Motorsteuerung der Reihenschaltung erreichen.

Nachteilig an einem numerischen Steuergerät dieser Art ist es, dass die Motorsteuerungen, sowie die numerische Steuereinheit von unabhängigen Taktsignalen gesteuert werden, d.h. nicht synchron zueinander laufen. Deshalb müssen die Motorsteuerungen in regelmäßigen Zeitabständen mit der numerischen Steuereinheit synchronisiert werden.

Die EP 0 504 907 A2 beschreibt ebenfalls ein numerisches Steuergerät, bestehend aus einer numerischen Steuereinheit und mehreren Motorsteuereinheiten, die über serielle Kommunikationsleitungen in Form einer Reihenschaltung miteinander verbunden sind. Zusätzlich ist eine weitere serielle Kommunikationsleitung vorgesehen, die die letzte Motorsteuereinheit wieder mit der numerischen Steuereinheit verbindet, so dass eine Ringstruktur gebildet ist. Diese Struktur liegt dem im Stand der Technik bekannten SERCOS-System zugrunde.

Verfahren zur Synchronisation sind im Stand der Technik bekannt. Sie werden unter anderem bei Feldbussystemen wie dem PROFIBUS oder auch beim Ethernet, das von allem aus der Bürotechnik bekannt ist, eingesetzt. Zur Synchronisation werden vom Hauptrechner (Busmaster) in zyklischen Zeitabständen Synchronisationsinformationen an die Reglereinheiten (Slaves) gesendet. Diese synchronisieren mit Hilfe der Synchronisationsinformationen ihre Ablaufsteuerung, d.h. sie korrigieren den Phasenfehler zwischen dem Empfang von Sollwerten und der Erfassung von Istwerten, der sich seit der letzten Synchronisation durch die Frequenzabweichung der verschiedenen Taktgeneratoren ergeben hat. Die Synchronisationsinformationen werden dabei häufig in Form von Datenpaketen (auch als Datentelegramme bezeichnet) gesendet. Dabei kann es sich um reine Synchronisationspakete handeln, oder um Datenpakete, die sowohl Synchronisationsinformationen als auch Nutzdaten enthalten.

In der beschriebenen Systemarchitektur - Reihenschaltung von Hauptrechner und Reglereinheiten - ergibt sich aufgrund der Tatsache, dass Hauptrechner und Reglereinheiten von verschiedenen, voneinander unabhängigen Taktsignalen betrieben werden, bei der Übertragung der Synchronisationsinformationen ein weiteres Problem. Je nach Phasenlage des Taktsignals der Reglereinheit ist der Empfang eines Datenpakets und damit das Eintreffen der Synchronisationsinformation um bis zu eine Taktperiode verzögert. Dieser Effekt ist auch unter dem Fachbegriff "Jitter" bekannt.

Der Jitter führt auch dazu, dass die Datenpakete, insbesondere die darin enthaltenen Synchronisationsinformationen, nicht mit einer konstanten Verzögerungszeit zur darauf folgenden Reglereinheit der Reihenschaltung weitergeleitet werden. Das bedeutet, dass die Synchronisierung umso unzuverlässiger arbeitet, je weiter eine Reglereinheit vom Hauptrechner entfernt ist, d.h. je mehr Reglereinheiten die Synchronisationsinformationen durchlaufen, weil mit jeder durchlaufenen Reglereinheit die maximale zeitliche Abweichung in der Übertragung der Synchronisationsinformationen steigt. Da sich die Änderung der Phasenlage der Taktsignale von Hauptrechner und Reglereinheiten zueinander weitgehend aus den Toleranzen der Taktgeneratoren und daraus resultierenden Unterschieden in der Taktfrequenz ergibt, ist dieser Effekt periodisch.

Eine mögliche Folge einer fehlerhaften Synchronisation ist, dass die in einer Reglereinheit gemessenen Istwerte mit einer Störung überlagert werden. Diese kann dadurch zustande kommen, dass sich die Zeitpunkte des Eintreffens von Sollwerten relativ zu den Zeitpunkten der Messung von Istwerten in den Reglereinheiten verschieben. Besonders wenn das Eintreffen eines Sollwertes mit der Umwandlung eines analogen Messsignals in einen digitalen Messwert zusammenfällt, kann der Messwert geringfügig verfälscht werden. Da die Beeinflussung der Messwerte vom Jitter abhängt und sich dieser periodisch ändert, spricht man auch von einem Schwebungseffekt. Die Folge davon ist eine geringere Genauigkeit der von der Numerischen Steuerung gesteuerten Werkzeugmaschine bzw. eine schlechtere Qualität, insbesondere der Oberflächengüte, der von der Werkzeugmaschine gefertigten Teile. Da die Störungen vergleichsweise niedrige Frequenzen aufweisen, ist es in der Praxis nicht möglich, sie in den Regelkreisen herauszufiltern, weil dadurch die Regelgeschwindigkeit soweit reduziert würde, dass kein sinnvoller Betrieb der Reglereinheit mehr gegeben wäre.

Eine Lösung, um eine zuverlässige Übertragung von Synchronisationsinformationen auch über mehrere Reglereinheiten hinweg zu erreichen ist, den Hauptrechner und die Reglereinheiten mit dem gleichen Taktsignal zu betreiben.

Die DE 100 48 191 A1 beschreibt ein Verfahren zur Synchronisierung einer Mehrzahl von Bussystemen. Dabei werden von einer Empfangseinheit eines Bussystems Synchronisationssignale dem Phasenregler einer phasenverriegelten Schleife (phase locked loop; PLL) mit einem Taktgeber zugeführt. Der Phasenregler ermittelt den momentanen Phasenfehler und regelt den Taktgeber derart nach, dass der Taktgeber zwischen zwei Synchronisationssignalen eine Sollanzahl von Taktsignalen ausgibt. Das Taktsignal wird allen Sendeeinheiten der Bussysteme als zentraler Takt zugeführt.

Nachteil dieses Verfahrens ist, dass bei hohen Genauigkeitsanforderungen die Synchronisationssignale in kurzen Zeitabständen gesendet werden müssen, um den Phasenfehler des Taktgebers gering zu halten. Das gilt insbesondere bei einem System mit der oben beschriebenen Architektur, da trotz Synchronisierung der Phasenfehler der Reglereinheiten gegenüber dem Taktsignal des Hauptrechners mit jedem Modul in der Reihenschaltung

EP 1 408 386 A2 offenbart die Merkmale des Oberbegriffs des Anspruchs 1.

Es ist daher Aufgabe der Erfindung, ein modulares numerisches Steuergerät anzugeben, mit der Daten, insbesondere Synchronisationsinformationen, mit einem niedrigen Jitter übertragen werden können.

Diese Aufgabe wird gelöst durch ein modulares numerisches Steuergerät mit Low-Jitter Synchronisation nach Anspruch 1. Vorteilhafte Details dieses modularen numerischen Steuergeräts ergeben sich aus den von Anspruch 1 abhängigen Ansprüchen.

Es wird ein modulares numerisches Steuergerät mit Low-Jitter Synchronisation vorgeschlagen, das einen Hauptrechner und wenigstens eine Reglereinheit umfasst, die, ausgehend vom Hauptrechner mittels serieller Datenübertragungskanäle in Form einer Reihenschaltung miteinander verbunden sind. Die wenigstens eine Reglereinheit enthält eine erste Empfängereinheit, um einen aus Richtung des Hauptrechners eintreffenden seriellen Datenstrom zu empfangen und eine erste Sendeeinheit, um einen seriellen Datenstrom auszugeben. Darüber hinaus ist in der wenigstens einen Reglereinheit eine Taktrückgewinnungseinheit vorgesehen, die aus dem an der ersten Empfängereinheit ankommenden seriellen Datenstrom ein Synchrontaktsignal ableitet und der ersten Sendeeinheit zuführt, die es als Sendetaktsignal verwendet, so dass der an der ersten Empfängereinheit ankommende serielle Datenstrom und der von der ersten Sendeeinheit ausgegebene serielle Datenstrom phasenstarr miteinander gekoppelt sind.

Weitere Vorteile sowie Einzelheiten der vorliegenden Erfindung ergeben sich aus der nachfolgenden Beschreibung einer bevorzugten Variante eines modularen numerischen Steuergeräts mit Low-Jitter Synchronisation anhand der Figuren. Dabei zeigt
Figur 1 ein Zeitdiagramm zur Veranschaulichung der Ursache für Jitter bei der Übertragung von Synchronisationsinformationen nach dem Stand der Technik,
Figur 2 ein Blockdiagramm eines erfindungsgemäßen modularen numerischen Steuergeräts,
Figur 3 ein Zeitdiagramm zur Veranschaulichung des zeitlichen Zusammenhangs der Datenströme.

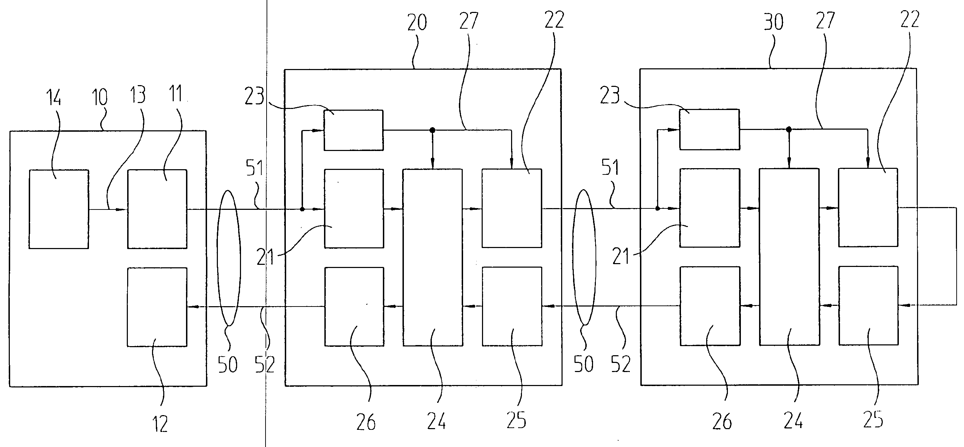

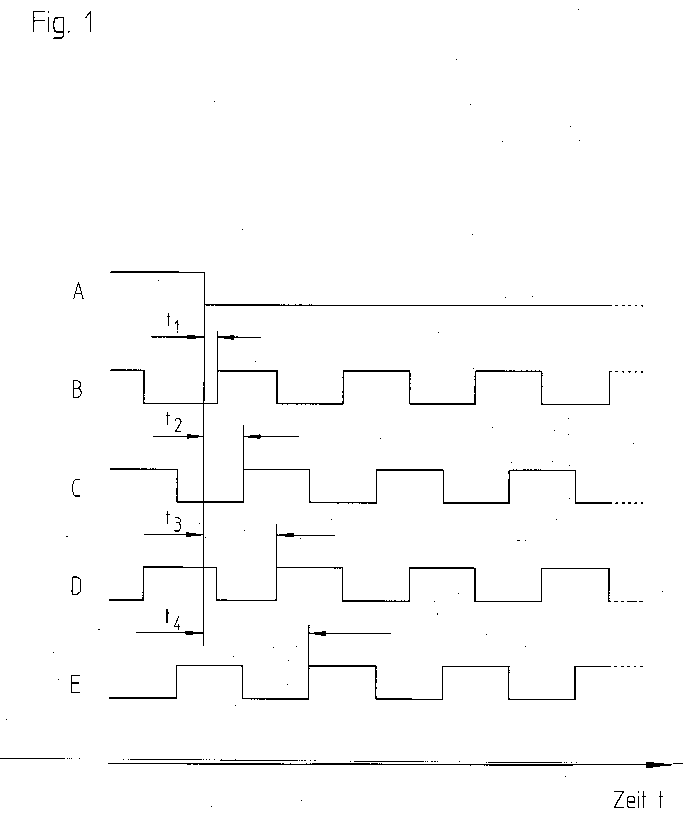

Einleitend wurde die Ursache für das Auftreten von Jitter bei der Übertragung von Synchronisationsinformationen nach dem Stand der Technik beschrieben. Das soll durch das Zeitdiagramm in Figur 1 näher erläutert werden. Ein Signal A signalisiert mit einer fallenden Signalflanke den Zeitpunkt des Eintreffens eines Datenpakets, die Signale B, C, D, E zeigen Taktsignale einer Reglereinheit mit verschiedener Phasenlage. Es soll angenommen werden, dass die Verarbeitung des Datenpakets mit der ersten steigenden Taktflanke des Taktsignals B, C, D, E beginnt. Das bedeutet, dass die Verarbeitung des Datenpakets bei Taktsignal B nach der Zeit t₁ beginnt, bei Taktsignal C nach der Zeit t₂, bei Taktsignal D nach der Zeit t₃ und bei Taktsignal E nach der Zeit t₄. Für den Fachmann ist offensichtlich, dass die maximale zeitliche Abweichung zwischen zwei aufeinander folgend empfangenen Datenpaketen der Periodendauer des Taktsignals B, C, D, E entspricht.

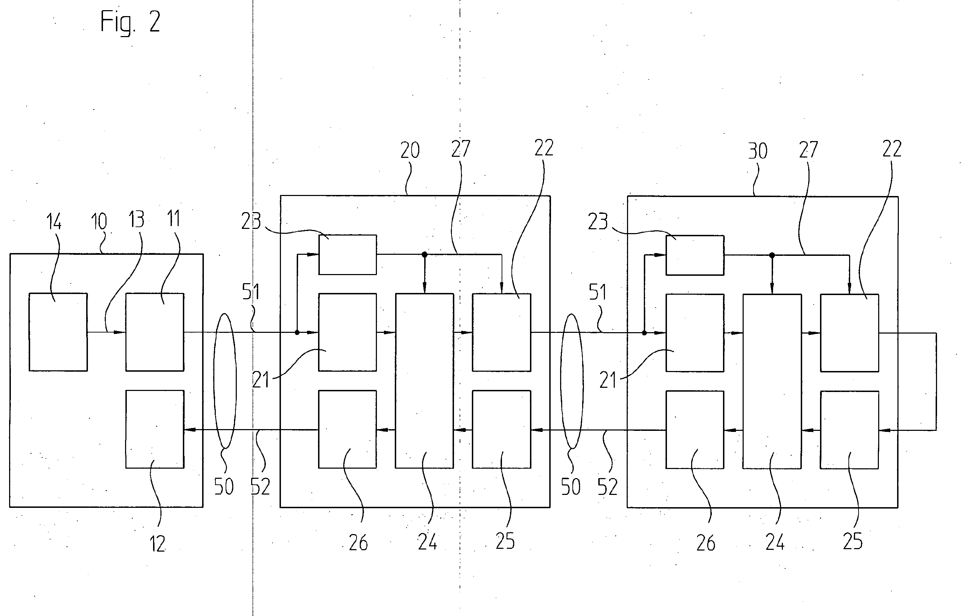

Figur 2 zeigt ein Blockdiagramm eines erfindungsgemäßen modularen numerischen Steuergeräts. Es besteht aus einem Hauptrechner 10 und zwei Reglereinheiten 20, 30, die mittels serieller Datenübertragungskanäle 50 in Form einer Reihenschaltung miteinander verbunden sind. Die Datenübertragungskanäle 50 bestehen aus einem Sendekanal 51 und einem Empfangskanal 52, wobei der Sendekanal 51 dazu dient, einen seriellen Datenstrom vom Hauptrechner 10 in Richtung der Reglereinheiten 20, 30 zu übertragen. Der Empfangskanal 52 dient dagegen zur Übertragung eines seriellen Datenstroms von den Reglereinheiten 20, 30 zum Hauptrechner 10. Die Reglereinheit 30 bildet dabei die abschließende Reglereinheit 30 der Reihenschaltung. Aus Gründen der Übersichtlichkeit sind in Figur 2 nur zwei Reglereinheiten 20, 30 dargestellt. Es sei an dieser Stelle ausdrücklich darauf hingewiesen, dass ein erfindungsgemäßes modulares numerisches Steuergerät eine Vielzahl von Reglereinheiten 20, 30 aufweisen kann.

Der Hauptrechner 10 enthält eine Hauptsendeeinheit 11, sowie eine Hauptempfängereinheit 12. Der Hauptsendeeinheit 11 ist ein Leittaktsignal 13 zugeführt, das in einem Leittaktgenerator 14 erzeugt wird. Der Hauptrechner 10 sendet mit der Hauptsendeeinheit 11 Informationen in Form von seriellen Datenströmen über den Datenübertragungskanal 50 zur ersten Reglereinheit 20 in der Reihenschaltung. Die Datenströme weisen dabei eine Datenübertragungsrate auf, die identisch oder proportional zur Frequenz des Leittaktsignals 13 ist. Es können beliebige Daten übertragen werden, wie beispielsweise Sollwerte als Vorgabe für die Regelkreise in den Reglereinheiten 20, 30, Daten zur Initialisierung der Reglereinheiten 20, 30 oder auch Anforderungsbefehle von Daten aus den Reglereinheiten 20, 30. Zusätzlich kann der Datenstrom Synchronisationsinformationen enthalten, um die Reglereinheiten 20, 30 mit dem Leittaktsignal 13 zu synchronisieren.

Eine verbreitete Methode, Informationen mit Hilfe von seriellen Datenströmen zu übertragen, ist die sog. Paketübertragung. Dabei werden die zu übertragenden Daten in Datenpakete (auch als Übertragungsrahmen oder Frames bezeichnet) mit genau definiertem Aufbau eingebaut. Zur Erhöhung der Übertragungssicherheit verfügen solche Datenpakete neben den Nutzdaten meist über zusätzliche Informationen, wie z.B. eine definierte Anfangssequenz (Startbits, -bytes), eine definierte Schlusssequenz (Stoppbits, -bytes), Informationen über die Länge des Datenpakets und Prüfsummen. Anhand dieser Zusatzinformationen kann der Empfänger des Datenpakets feststellen, ob die Übertragung fehlerfrei war. Sollen in einem Datenpaket Daten zu mehreren verschiedenen Empfängern gesendet werden, ist es von Vorteil, im Übertragungsrahmen Bereiche für gemeinsame Daten, die zu allen Empfängern gesendet werden und Bereiche, die einzelnen Empfängern zugeordnet sind, vorzusehen.

Die Reglereinheiten 20, 30 beinhalten eine erste Empfängereinheit 21, eine erste Sendeeinheit 22, eine Taktrückgewinnungseinheit 23, eine Verarbeitungseinheit 24, sowie eine zweite Empfängereinheit 25 und eine zweite Sendeeinheit 26. Aus Gründen der Übersichtlichkeit wurde auf eine Darstellung der Regelkreise zur Ansteuerung von Antrieben, mit der dazugehörigen Erzeugung von Steuersignalen, sowie der Erfassung von Istwerten, verzichtet.

Die erste Empfängereinheit 21 dient dazu, serielle Datenströme, die aus Richtung des Hauptrechners 10 eintreffen, zu empfangen und die darin enthaltenen Daten zur Verarbeitungseinheit 24 weiterzuleiten. Dort werden die Daten in determinierten Zeitintervallen verarbeitet und anschließend an die erste Sendeeinheit 22 weitergeleitet, die sie, wiederum in Form eines seriellen Datenstroms an die darauffolgende Reglereinheit 20, 30 weitersendet. Der ersten Sendeeinheit 22 wird dazu von der Taktrückgewinnungseinheit 23 ein Synchrontaktsignal 27 zugeführt, das die Taktrückgewinnungseinheit 23 aus dem seriellen Datenstrom gewinnt. Das Synchrontaktsignal 27 ist somit phasenstarr mit dem Leittaktsignal 13 gekoppelt. Phasenstarre Kopplung bedeutet in diesem Zusammenhang, dass das Synchrontaktsignal 27 zwar gegenüber dem Leittaktsignal 13 zeitlich verzögert ist, diese Verzögerung aber konstant ist und keine Phasensprünge auftreten. In anderen Worten tritt zwischen dem Synchrontaktsignal 27 und dem Leittaktsignal 13 nur ein sehr niedriger Jitter auf. Da die erste Sendeeinheit 22 das Synchrontaktsignal 27 dazu verwendet, den Datenstrom zur nächsten Reglereinheit 20, 30 zu senden, ist gewährleistet, dass alle Datenströme, ausgehend vom Hauptrechner 10 bis zur abschließenden Reglereinheit 30 der Reihenschaltung einen niedrigen Jitter zueinander aufweisen.

Das Synchrontaktsignal 27 ist darüber hinaus auch der Verarbeitungseinheit 24 der Reglereinheiten 20, 30 zugeführt. Dort wird mit Hilfe des Synchrontaktsignals 27 wenigstens ein Taktsignal zur Steuerung der Abläufe in der Verarbeitungseinheit 24 erzeugt. Dadurch wird erreicht, dass auch alle Verarbeitungseinheiten 24 einen niedrigen Jitter zum Leittaktsignal 14 aufweisen. Zur Erzeugung des wenigstens einen Taktsignals können bekannte Maßnahmen aus dem Stand der Technik eingesetzt werden. Besonders vorteilhaft ist es, das Synchrontaktsignal 27 einer phasenverriegelten Schleife (phase locked loop; PLL) zuzuführen, da eine PLL auch bei Ausfall des Synchrontaktsignals 27 weiter Taktsignale ausgibt. Dadurch ist gewährleistet, dass die Reglereinheiten 20, 30 auch im Fehlerfall, z.B. bei Unterbrechung eines Datenübertragungskanals 50 oder bei Ausfall des Hauptrechners 10 funktionsfähig bleiben und ggf. die von ihnen gesteuerten Antriebe kontrolliert stoppen können.

Da die Taktrückgewinnungseinheit 23 das Synchrontaktsignal 27 aus dem eintreffenden seriellen Datenstrom gewinnt, ist es besonders vorteilhaft, wenn der serielle Datenstrom so codiert ist, dass auch während Übertragungslücken, also in der Zeit, in der kein Datenpaket übertragen wird, Pegelwechsel auftreten. Andernfalls kann zwischen Leittaktsignal 13 und Synchrontaktsignal 27 ein Phasenfehler auftreten, der umso größer wird, je länger die Übertragungslücke andauert. Als besonders geeignet hat sich erwiesen, für den seriellen Datenstrom eine Bitgruppencodierung vom Typ 4B5B einzusetzen. Dabei werden die zu übertragenden Daten in Gruppen von 4 Bit aufgeteilt, die jeweils mit 5 Bit codiert werden, mit dem Ziel, möglichst viele Pegelwechsel zu erzeugen und so eine Taktrückgewinnung zu begünstigen.

Eine weit verbreitete serielle Datenschnittstelle, die diese Art von Bitgruppencodierung verwendet, ist vor allem aus dem Bereich der Local Area Networks (LAN) bekannt und trägt die Bezeichnung FAST ETHERNET (Norm IEEE Std. 802.3-2002). Das Datenübertragungsverfahren, wie es im Standard IEEE 802.3 beschrieben ist, ist für zeitkritische Anwendungen zwar nur bedingt geeignet, da es vorwiegend für die Bürotechnik zur Übertragung großer Datenmengen entwickelt wurde und dadurch kein determiniertes Zeitverhalten aufweist. Auf der Basis der physikalischen Ebene des Standards IEEE 802.3 (Layer 1 des OSI/ISO Schichtenmodells) kann jedoch ein echtzeitfähiges Datenübertragungssystem aufgebaut werden. Das hat insbesondere den Vorteil, dass auf eine bewährte Technik zurückgegriffen werden kann, zu der auf dem Markt eine große Anzahl von Bauteilen zu einem günstigen Preis zur Verfügung stehen.

Um in einem modularen numerischen Steuergerät, wie es in Figur 2 beschrieben ist, Synchronisationsinformationen vom Hauptrechner 10 zu den Reglereinheiten 20, 30 zu senden, können bekannte Verfahren aus dem Stand der Technik verwendet werden, insbesondere Synchronisationspakete und Datenpakete, die neben Nutzdaten auch Synchronisationsinformationen enthalten. Durch die phasenstarr gekoppelten seriellen Datenströme und durch die Verwendung des Synchrontaktsignals 27 in den Verarbeitungseinheiten 24 ist gewährleistet, dass die Synchronisationsinformationen stets mit konstanter Verzögerungszeit bei den Reglereinheiten 20, 30 eintreffen.

In der Praxis ist es sinnvoll, Informationen sowohl vom Hauptrechner 10 zu den Reglereinheiten 20, 30 als auch in umgekehrter Richtung übertragen zu können. Die Möglichkeit, Informationen von den Reglereinheiten 20, 30 zum Hauptrechner 10 übertragen zu können, ist in diesem bevorzugten Ausführungsbeispiel dadurch realisiert, dass bei der abschließenden Reglereinheit 30 in der Reihenschaltung der Ausgang der ersten Sendeeinheit 22 mit dem Eingang der zweiten Empfängereinheit 25 verbunden ist. Zusätzlich sind bei benachbarten Reglereinheiten 20, 30 die zweiten Sendeeinheiten 26 mit den zweiten Empfängereinheiten 25 verbunden. Die zweite Sendeeinheit 26 der ersten Reglereinheit 20 in der Reihenschaltung ist schließlich an die Hauptempfängereinheit 12 des Hauptrechners 10 angeschlossen. Die Verbindungen werden jeweils durch die Empfangskanäle 52 der Datenübertragungskanäle 50 hergestellt. Auf diese Art und Weise ist eine Ringstruktur gebildet, über die der ursprünglich von der Hauptsendeeinheit 11 des Hauptrechners 10 gesendete Datenstrom wieder zum Hauptrechner 10 zurückgeschickt werden kann. Da die Daten, die im seriellen Datenstrom enthalten sind, jede Reglereinheit 20, 30 sowohl in Vorwärts- als auch Rückwärtsrichtung passieren und in jeder Reglereinheit 20, 30 in den Verarbeitungseinheiten 24 verarbeitet werden, ist dadurch ein Datentransfer zwischen Hauptrechner 10 und der Reglereinheit 20, bzw. zwischen den Reglereinheiten 20, 30 möglich.

Darüber hinaus kann durch Auswertung der Informationen, die über den Datenstrom zur Hauptempfängereinheit 12 gelangen, festgestellt werden, ob die Datenübertragung zwischen Hauptrechner 10 und den Reglereinheiten 20, 30 fehlerfrei funktioniert.

In der bevorzugten Ausführungsform in Figur 2 ist für die Übertragung von Informationen von den Reglereinheiten 20, 30 zum Hauptrechner 10 keine phasenstarre Kopplung der Datenströme vorgesehen, da hier geringe Schwankungen in der Übertragungszeit häufig toleriert werden können. Für den Fachmann ist es aber offensichtlich, dass durch die oben beschriebenen Maßnahmen auch hier eine phasenstarre Kopplung der Datenströme erreicht werden kann.

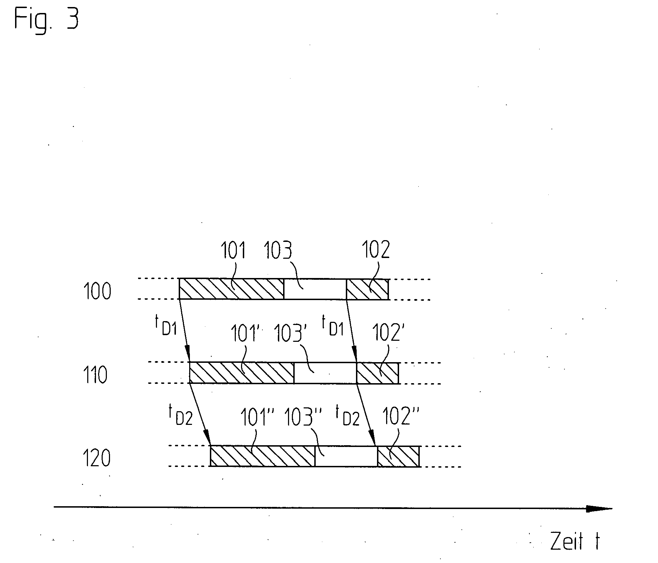

Anhand der Figur 3 soll nun der zeitliche Zusammenhang der Datenströme anhand eines Zeitdiagramms veranschaulicht werden. Ein erstes Signal 100 zeigt dabei das Timing des Datenstroms, der von der Hauptsendeeinheit 12 des Hauptrechners 10 abgeschickt wird. Ein zweites Signal 110 zeigt den zeitlichen Verlauf des Datenstroms am Ausgang der ersten Sendeeinheit 22 der ersten Reglereinheit 20 der Reihenschaltung, ein drittes Signal 120 den Datenstrom am Ausgang der ersten Sendeeinheit 22 der abschließenden Reglereinheit 30 der Reihenschaltung. In den dargestellten Datenströmen werden Informationen in Form von Datenpaketen 101, 102, 101', 102', 101", 102" übertragen. Zwischen den Datenpaketen 101, 102, 101', 102', 101", 102" können sich Übertragungslücken 103, 103', 103" befinden. Wie in Figur 3 dargestellt, ist der Startzeitpunkt der Übertragung des Datenpakets 101' des zweiten Signals 110 gegenüber dem Startzeitpunkt der Übertragung des Datenpakets 101 des ersten Signals 100 um eine erste Verzögerungszeit t_{D1} verzögert. Ebenso ist der Startzeitpunkt der Übertragung des Datenpakets 101" des dritten Signals 120 gegenüber dem Startzeitpunkt der Übertragung des Datenpakets 101' des zweiten Signals 110 um eine zweite Verzögerungszeit t_{D2} verzögert. Da die seriellen Datenströme phasenstarr miteinander gekoppelt sind und die Daten in der Verarbeitungseinheit 24 der Reglereinheiten 20, 30 in determinierten Zeitabständen verarbeitet werden, ist sichergestellt, dass die Verzögerungszeiten t_{D1} und t_{D2} konstant sind.

## Patentansprüche

1. Modulares numerisches Steuergerät mit Low-Jitter Synchronisation, das einen Hauptrechner (10) und wenigstens eine Reglereinheit (20, 30) umfasst, die, ausgehend vom Hauptrechner (10), mittels serieller Datenübertragungskanäle (50) in Form einer Reihenschaltung miteinander verbunden sind, wobei die wenigstens eine Reglereinheit (20, 30) enthält:
- eine erste Empfängereinheit (21), um einen aus Richtung des Hauptrechners (10) eintreffenden seriellen Datenstrom zu empfangen,
- eine erste Sendeeinheit (22), um einen seriellen Datenstrom in Richtung einer abschließenden Reglereinheit (30) der Reihenschaltung auszugeben,
- eine zweite Empfängereinheit (25), um einen aus Richtung der abschließenden Reglereinheit (30) der Reihenschaltung eintreffenden zweiten seriellen Datenstrom zu empfangen,
- eine Verarbeitungseinheit (24), die dazu geeignet ist, die im zweiten seriellen Datenstrom enthaltenen Daten zu verarbeiten,
- eine zweite Sendeeinheit (26), um die verarbeiteten Daten in Form eines seriellen Datenstroms in Richtung des Hauptrechners (10) auszugeben und
- eine Taktrückgewinnungseinheit (23), die aus dem an der ersten Empfängereinheit (21) ankommenden seriellen Datenstrom ein Synchrontaktsignal (27) ableitet,
**dadurch gekennzeichnet, dass**
- die Taktrückgewinnungseinheit (23) das Synchrontaktsignal (27) der ersten Sendeeinheit (22) zuführt, die das Synchrontaktsignal (27) als Sendetaktsignal verwendet, so dass der an der ersten Empfängereinheit (21) ankommende serielle Datenstrom und der von der ersten Sendeeinheit (22) ausgegebene serielle Datenstrom phasenstarr miteinander gekoppelt sind.

2. Modulares numerisches Steuergerät nach Anspruch 1, **dadurch gekennzeichnet, dass** der Verarbeitungseinheit (24) das Synchrontaktsignal (27) zugeführt ist und die Verarbeitungseinheit (24) Daten, die im empfangenen seriellen Datenstrom enthaltenen sind, in determinierten Zeitintervallen verarbeitet und die verarbeiteten Daten der ersten Sendeeinheit (22) zuführt.

3. Modulares numerisches Steuergerät nach Anspruch 2, **dadurch gekennzeichnet, dass** die Verarbeitungseinheit (24) der wenigstens einen Reglereinheit (20, 30) durch im seriellen Datenstrom übertragene Synchronisationsinformationen synchronisierbar ist.

4. Modulares numerisches Steuergerät nach einem der vorhergehenden Ansprüche, **dadurch gekennzeichnet, dass** Daten im seriellen Datenstrom als Datenpakete übertragbar sind.

5. Modulares numerisches Steuergerät nach Anspruch 4, **dadurch gekennzeichnet, dass** die Datenpakete Synchronisationsinformationen enthalten.

6. Modulares numerisches Steuergerät nach einem der vorhergehenden Ansprüche, **dadurch gekennzeichnet, dass** der serielle Datenstrom derart codiert ist, dass auch während Übertragungslücken Pegelwechsel auftreten.

7. Modulares numerisches Steuergerät nach Anspruch 6, **dadurch gekennzeichnet, dass** der serielle Datenstrom eine Bitgruppencodierung vom Typ 4B5B aufweist.

8. Modulares numerisches Steuergerät nach einem der vorhergehenden Ansprüche, **dadurch gekennzeichnet, dass** die Datenübertragungskanäle (50) aus einem Sendekanal (51), über den ein serieller Datenstrom vom Hauptrechner (10) in Richtung der Reglereinheiten (20, 30) übertragbar ist und einem Empfangskanal (52), über den ein serieller Datenstrom von den Reglereinheiten (20, 30) in Richtung des Hauptrechners (10) übertragbar ist, bestehen.

9. Modulares numerisches Steuergerät nach einem der vorhergehenden Ansprüche, **dadurch gekennzeichnet, dass** bei der abschließenden Reglereinheit (30) der Reihenschaltung der Ausgang der ersten Sendeeinheit (22) mit dem Eingang der zweiten Empfangseinheit (25) verbunden ist.

## Claims

1. Modular numerical controller with low-jitter synchronization, which comprises a main computer (10) and at least one regulator unit (20, 30) which are connected to one another in the form of a series circuit by means of serial data transmission channels (50) starting from the main computer (10), the at least one regulator unit (20, 30) containing:
- a first receiver unit (21) for receiving a serial data stream arriving from the direction of the main computer (10),
- a first transmitting unit (22) for outputting a serial data stream in the direction of a final regulator unit (30) in the series circuit,
- a second receiver unit (25) for receiving a second serial data stream arriving from the direction of the final regulator unit (30) in the series circuit,
- a processing unit (24) which is suitable for processing the data contained in the second serial data stream,
- a second transmitting unit (26) for outputting the processed data in the form of a serial data stream in the direction of the main computer (10), and
- a clock recovery unit (23) which derives a synchronous clock signal (27) from the serial data stream arriving at the first receiver unit (21),
**characterized in that**
- the clock recovery unit (23) supplies the synchronous clock signal (27) to the first transmitting unit (22) which uses the synchronous clock signal (27) as a transmission clock signal, with the result that the serial data stream arriving at the first receiver unit (21) and the serial data stream output by the first transmitting unit (22) are coupled to one another in a phase-locked manner.

2. Modular numerical controller according to Claim 1, **characterized in that** the synchronous clock signal (27) is supplied to the processing unit (24) and the processing unit (24) processes data contained in the received serial data stream in determined intervals of time and supplies the processed data to the first transmitting unit (22).

3. Modular numerical controller according to Claim 2, **characterized in that** the processing unit (24) of the at least one regulator unit (20, 30) can be synchronized by means of synchronization information transmitted in the serial data stream.

4. Modular numerical controller according to one of the preceding claims, **characterized in that** data can be transmitted in the serial data stream in the form of data packets.

5. Modular numerical controller according to Claim 4, **characterized in that** the data packets contain synchronization information.

6. Modular numerical controller according to one of the preceding claims, **characterized in that** the serial data stream is coded in such a manner that level changes occur even during transmission gaps.

7. Modular numerical controller according to Claim 6, **characterized in that** the serial data stream has bit group coding of the type 4B5B.

8. Modular numerical controller according to one of the preceding claims, **characterized in that** the data transmission channels (50) consist of a transmission channel (51), which can be used to transmit a serial data stream from the main computer (10) in the direction of the regulator units (20, 30), and a reception channel (52) which can be used to transmit a serial data stream from the regulator units (20, 30) in the direction of the main computer (10).

9. Modular numerical controller according to one of the preceding claims, **characterized in that**, in the final regulator unit (30) in the series circuit, the output of the first transmitting unit (22) is connected to the input of the second receiving unit (25).

## Revendications

1. Appareil de commande numérique modulaire avec synchronisation à faible gigue comprenant un calculateur principal (10) et au moins une unité de régulation (20, 30) qui sont connectés l'un à l'autre à partir du calculateur principal (10), au moyen de canaux de transmission de données (50) série sous la forme d'un circuit série, dans lequel l'au moins une unité de régulation (20, 30) comporte :
- une première unité de réception (21), pour recevoir un flux de données série incident provenant de la direction du calculateur principal (10),
- une première unité d'émission (22), pour délivrer un flux de données série dans la direction d'une unité de régulation finale (30) du circuit série,
- une seconde unité de réception (25), pour recevoir un second flux de données série incident provenant de la direction de l'unité de régulation finale (30) du circuit série,
- une unité de traitement (24), qui est conçue pour traiter les données contenues dans le second flux de données série,
- une seconde unité d'émission (26), pour délivrer les données traitées sous la forme d'un flux de données série dans la direction du calculateur principal (10), et
- une unité de récupération d'horloge (23) qui déduit un signal d'horloge synchrone (27) à partir du flux de données série atteignant la première unité de réception (21),
**caractérisé en ce que**
- l'unité de récupération d'horloge (23) fournit le signal d'horloge synchrone (27) à la première unité d'émission (22), qui utilise le signal d'horloge synchrone (27) en tant que signal d'horloge d'émission de manière à ce que le flux de données série atteignant la première unité de réception (21) et le flux de données série délivré par la première unité d'émission (22) soient couplés l'un à l'autre de manière verrouillée en phase.

2. Appareil de commande numérique modulaire selon la revendication 1, **caractérisé en ce que** le signal d'horloge synchrone (27) est fourni à l'unité de traitement (24) et l'unité de traitement (24) traite à des intervalles de temps déterminés des données qui sont contenues dans le flux de données série reçu et fournit les données traitées à la première unité d'émission (22).

3. Appareil de commande numérique modulaire selon la revendication 2, **caractérisé en ce que** l'unité de traitement (24) de l'au moins une unité de régulation (20, 30) peut être synchronisée par des informations de synchronisation transportées dans le flux de données série.

4. Appareil de commande numérique modulaire selon l'une quelconque des revendications précédentes, **caractérisé en ce que** des données peuvent être transmises sous la forme de paquets de données dans le flux de données série.

5. Appareil de commande numérique modulaire selon la revendication 4, caractérisé en cc que les paquets de données contiennent des informations de synchronisation.

6. Appareil de commande numérique modulaire selon l'une quelconque des revendications précédentes, **caractérisé en ce que** le flux de données série est codé de manière à ce que des changements de niveau se produisent également pendant des intervalles entre transmissions.

7. Appareil de commande numérique modulaire selon la revendication 6, **caractérisé en ce que** le flux de données série comporte un codage de groupes de bits de type 4B5B.

8. Appareil de commande numérique modulaire selon l'une quelconque des revendications précédentes, **caractérisé en ce que** les canaux de transmission de données (50) sont constitués d'un canal d'émission (51), par l'intermédiaire duquel un flux de données série peut être transmis par le calculateur principal (10) dans la direction des unités de régulations (20, 30), et d'un canal de réception (52), par l'intermédiaire duquel un flux de données série peut être transmis par les unités de régulation (20, 30) dans la direction du calculateur principal (10).

9. Appareil de commande numérique modulaire selon l'une quelconque des revendications précédentes, **caractérisé en ce que**, pour la dernière unité de régulation (30) du circuit série, la sortie de la première unité d'émission (22) est connectée à l'entrée de la seconde unité de réception (25).
